# EUROPEAN PATENT APPLICATION

(11) **EP 4 676 180 A1**
(43) Date of publication of application: **07.01.2026**
(21) Application number: 25183588.0
(22) Date of filing: 18.06.2025
(51) Int. Cl.: H10B 12/00

(54) **SEMICONDUCTOR DEVICE INCLUDING ACTIVE PATTERNS AND BUFFER STRUCTURE**

(30) Priority: 01.07.2024 KR 20240086115
(71) Applicant: Samsung Electronics Co., Ltd., Suwon-si, Gyeonggi-do 16677 (KR)
(72) Inventor: JANG, Sunghwan, 16677 Suwon-si, Gyeonggi-do (KR); PARK, Hyojin, 16677 Suwon-si, Gyeonggi-do (KR)
(74) Representative: Kuhnen & Wacker Patent- und Rechtsanwaltsbüro PartG mbB

(57) **Abstract**

A semiconductor device is provided. The semiconductor device includes: a material pattern extending in a vertical direction (Z) and doped with a first impurities; a data storage structure (5) facing the material pattern and spaced apart from the material pattern; active patterns (50) provided between the material pattern and the data storage structure (5), wherein the active patterns (50) are stacked and spaced apart from each other in the vertical direction (Z), and respectively include first source/drain regions (50sd1) adjacent to the material pattern that are doped with the first impurities, second source/drain regions (50sd2) adjacent to the data storage structure (5), and channel regions (50ch) between the first source/drain regions (50sd1) and the second source/drain regions (50sd2); gates (60) stacked and spaced apart from each other in the vertical direction (Z), wherein the gates (60) vertically overlap the channel regions (50ch) of the active patterns (50); and a buffer structure (30) provided between the material pattern and the first source/drain regions (50sd1) of the active patterns (50).

## Description

### BACKGROUND

The present disclosure relates to a semiconductor device including active patterns and a buffer structure, and a method for forming the same.

Research into reducing the size of elements constituting a semiconductor device and improving performance thereof is being conducted. For example, in a dynamic random access memory (DRAM), research for reliably and stably forming elements with reduced sizes is being conducted. However, as the size of the elements are reduced, dispersion characteristics of the semiconductor device are deteriorating.

### SUMMARY

One or more example embodiments provide a semiconductor device having improved performance.

One or more example embodiments also provide a method for forming the semiconductor device.

According to an aspect of an example embodiment, a semiconductor device includes: a material pattern extending in a vertical direction and doped with a first impurities; a data storage structure facing the material pattern and spaced apart from the material pattern; active patterns provided between the material pattern and the data storage structure, wherein the active patterns are stacked and spaced apart from each other in the vertical direction, and respectively include first source/drain regions adjacent to the material pattern that are doped with the first impurities, second source/drain regions adjacent to the data storage structure, and channel regions between the first source/drain regions and the second source/drain regions; gates stacked and spaced apart from each other in the vertical direction, wherein the gates vertically overlap the channel regions of the active patterns; and a buffer structure provided between the material pattern and the first source/drain regions of the active patterns.

According to another aspect of an example embodiment, a semiconductor device includes: a material pattern having a pillar shape extending in a vertical direction and including a doped material layer; a data storage structure facing the material pattern in a first horizontal direction; active patterns spaced apart from each other and stacked in the vertical direction between the material pattern and the data storage structure; and gates spaced apart from each other and stacked in the vertical direction between the material pattern and the data storage structure, wherein the gates vertically overlap the active patterns; and a buffer structure provided between the material pattern and the active patterns.

According to another aspect of an example embodiment, a semiconductor device includes: a memory region; and a peripheral region vertically overlapping the memory region and including a peripheral circuit. The memory region includes: a first data storage structure and a second data storage structure, facing each other in a first horizontal direction; a material pattern provided between the first data storage structure and the second data storage structure; first active patterns stacked and spaced apart from each other in a vertical direction between the first data storage structure and the material pattern; second active patterns stacked and spaced apart from each other in the vertical direction between the second data storage structure and the material pattern; and a buffer structure provided between the first active patterns and the material pattern, and between the second active patterns and the material pattern. The material pattern includes a first semiconductor material layer doped with a first impurities. The buffer structure includes a second semiconductor material layer doped with the first impurities. The first active patterns and the second active patterns, adjacent to the buffer structure, include source/drain regions doped with the first impurities.

### BRIEF DESCRIPTION OF DRAWINGS

The above and other aspects and features will be more apparent from the following detailed description, taken in conjunction with the accompanying drawings, in which:
FIG. 1 is a schematic perspective view illustrating a semiconductor device according to an example embodiment;
FIG. 2 is a schematic perspective view illustrating a semiconductor device according to an example embodiment;
FIG. 3 is a partially enlarged cross-sectional view schematically illustrating a semiconductor device according to an example embodiment;
FIG. 4 is a partially enlarged cross-sectional view schematically illustrating a semiconductor device according to an example embodiment;
FIG. 5 is a partially enlarged cross-sectional view schematically illustrating a semiconductor device according to an example embodiment
FIG. 6 is a partially enlarged cross-sectional view schematically illustrating a semiconductor device according to an example embodiment;
FIG. 7 is a partially enlarged cross-sectional view schematically illustrating a semiconductor device according to an example embodiment;
FIG. 8 is a partially enlarged cross-sectional view schematically illustrating a semiconductor device according to an example embodiment;
FIG. 9 is a partially enlarged cross-sectional view schematically illustrating a semiconductor device according to an example embodiment;
FIG. 10 is a partially enlarged cross-sectional view schematically illustrating a semiconductor device according to an example embodiment;
FIG. 11 is a partially enlarged cross-sectional view schematically illustrating a semiconductor device according to an example embodiment;
FIG. 12A is a partially enlarged cross-sectional view schematically illustrating a semiconductor device according to an example embodiment;
FIG. 12B is a partially enlarged cross-sectional view schematically illustrating a semiconductor device according to an example embodiment;
FIGS. 13, 14A, and 14B are views illustrating examples of a semiconductor device according to an example embodiment;
FIG. 15A is a partially enlarged cross-sectional view schematically illustrating a semiconductor device according to an example embodiment;
FIG. 15B is a partially enlarged cross-sectional view schematically illustrating a semiconductor device according to an example embodiment;
FIG. 15C is a partially enlarged cross-sectional view schematically illustrating a semiconductor device according to an example embodiment;
FIG. 16 is a process flow diagram illustrating a method for forming a semiconductor device according to an example embodiment; and
FIGS 17 to 23 are views illustrating example method steps of a method for forming a semiconductor device according to an example embodiment.

### DETAILED DESCRIPTION

Hereinafter, example embodiments are described in detail with reference to the accompanying drawings. Terms such as "upper," "intermediate," and "lower" may be replaced with other terms, for example, terms such as "first," "second," and "third," and may be used to describe elements of the specification. Terms such as "first," "second," and "third" may be used to describe various elements, but the elements are not limited by the terms, and a "first element" may be referred to as a "second element." In the specification, terms such as "lower," "upper," "upper end," and "lower end" may be terms described based on the drawings. It will be understood that when an element or layer is referred to as being "on," "connected to" or "coupled to" another element or layer, it can be directly on, connected or coupled to the other element or layer, or intervening elements or layers may be present. By contrast, when an element is referred to as being "directly on," "directly connected to" or "directly coupled to" another element or layer, there are no intervening elements or layers present. Expressions such as "at least one from among," and "at least one of," when preceding a list of elements, modify the entire list of elements and do not modify the individual elements of the list. For example, the expression, "at least one from among a, b, and c," should be understood as including only a, only b, only c, both a and b, both a and c, both b and c, or all of a, b, and c. Embodiments described herein are example embodiments, and thus, the present disclosure is not limited thereto, and may be realized in various other forms. Each example embodiment provided in the following description is not excluded from being associated with one or more features of another example or another embodiment also provided herein or not provided herein but consistent with the present disclosure.

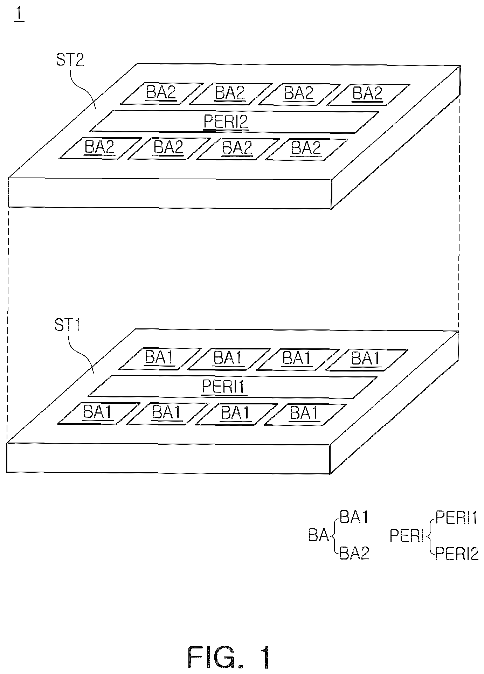

FIG. 1 is a schematic perspective view illustrating a semiconductor device according to an example embodiment.

Referring to FIG. 1, a semiconductor device 1 according to an example embodiment may include a first structure ST1 and a second structure ST2 vertically overlapping the first structure ST1. The second structure ST2 may be disposed on the first structure ST1.

In an example embodiment, the first structure ST1 may be a first chip structure including a memory region, and the second structure ST2 may be a second chip structure including a peripheral region including a peripheral circuit. The first structure ST1 and the second structure ST2 may be formed by being bonded by a bonding process such as a wafer bonding process. Therefore, the first structure ST1 may be in contact with and bonded to the second structure ST2.

The semiconductor device 1 may include a plurality of banks BA and an external peripheral region PERI.

The external peripheral region PERI may include a first peripheral region PERI1 within the first structure ST1 and a second peripheral region PERI2 within the second structure ST2. The external peripheral region PERI may be a peripheral region in which peripheral circuits for input/output of data or commands, or input of power/ground, are disposed.

Each of the plurality of banks BA may include a first bank region BA1 in the first structure ST1, and a second bank region BA2 in the second structure ST2.

The first bank region BA1 in the first structure ST1 may include memory cells disposed three-dimensionally. The second bank region BA2 in the second structure ST2 may include a peripheral circuit such as a sense amplifier, a sub-word line driver, or the like.

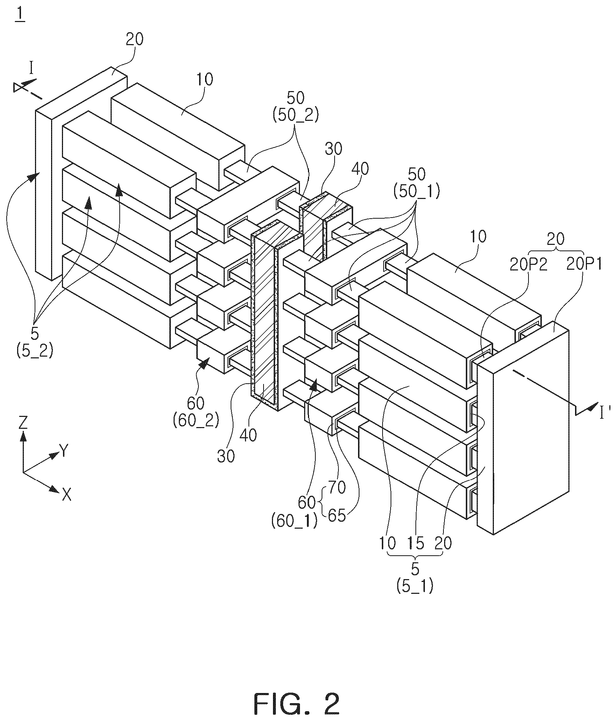

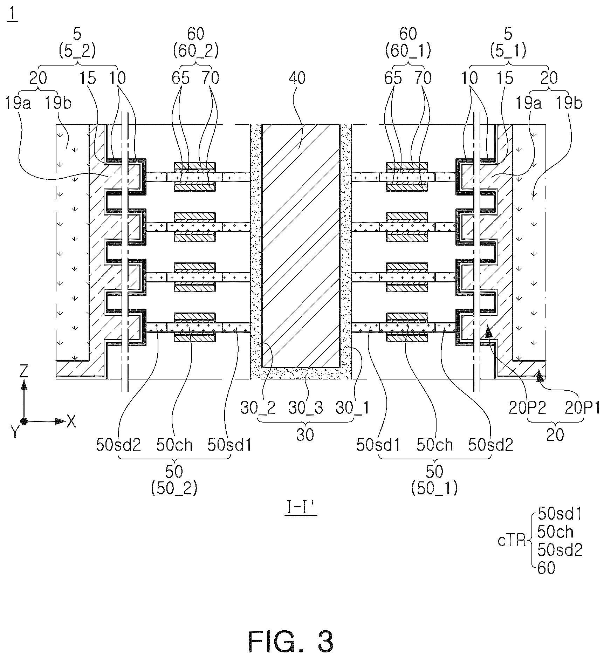

Next, with reference to FIGS. 2 and 3, a semiconductor device according to an example embodiment will be described. FIG. 2 is a perspective view schematically illustrating a portion of the first structure ST1 of FIG. 1 in order to explain a semiconductor device according to an example embodiment, and FIG. 3 is a cross-sectional view illustrating a portion taken along line I-I' of FIG. 2.

Referring to FIGS. 2 and 3, a semiconductor device 1 according to an example embodiment may include data storage structures 5, material patterns 40, buffer structures 30, active patterns 50, and gates 60.

The data storage structures 5 may include a first data storage structure 5_1 and a second data storage structure 5_2, facing each other, and spaced apart from each other in a first horizontal direction X.

The material patterns 40 may be disposed between the data storage structures 5. Each of the material patterns 40 may extend in a vertical direction Z. Each of the material patterns 40 may have a pillar shape extending in the vertical direction Z. The material patterns 40 may be bit lines.

The first data storage structure 5_1, the material patterns 40 and the second data storage structure 5_2, may be disposed in sequence while being spaced apart from each other in the first horizontal direction X. The semiconductor device 1 may include multiple first data storage structures 5_1 which are spaced apart from each other in the vertical direction Z and a second horizontal direction Y, perpendicular to the first horizontal direction X. The semiconductor device 1 may include multiple material patterns 40 which are spaced apart from each other in the vertical direction Z and the second horizontal direction Y. The semiconductor device 1 may include multiple first data storage structures 5_1 which are spaced apart from each other in the vertical direction Z and the second horizontal direction Y.

The active patterns 50 may be disposed between the material patterns 40 and the data storage structures 5. Between the material patterns 40 and the data storage structures 5, the active patterns 50 may be stacked while being spaced apart from each other in the vertical direction Z, and may be disposed in sequence while being spaced apart from each other in the second horizontal direction Y. Each of the active patterns 50 may extend in the first horizontal direction X.

The active patterns 50 may be formed of a semiconductor material. For example, each of the active patterns 50 may include a semiconductor material layer. Each of the active patterns 50 may include silicon. Each of the active patterns 50 may include single crystal silicon.

Each of the active patterns 50 may include a first source/drain region 50sd1, a second source/drain region 50sd2, and a channel region 50ch between the first and second source/drain regions 50sd1 and 50sd2. **In** each of the active patterns 50, a corresponding first source/drain region 50sd1, a corresponding channel region 50ch, and a corresponding second source/drain region 50sd2 may be arranged sequentially in a first direction, for example the first horizontal direction X. The material pattern 40 may be wider in the first direction than the buffer structure 30. The first and second source/drain regions 50sd1 and 50sd2 may have a first conductivity type. For example, the first and second source/drain regions 50sd1 and 50sd2 may have an N-type conductivity type.

The first source/drain regions 50sd1 of the active patterns 50 may be disposed between the channel region 50ch and the material patterns 40, and the second source/drain regions 50sd2 of the active patterns 50 may be disposed between the channel region 50ch and the data storage structures 5.

The gates 60 may be stacked while being spaced apart from each other in the vertical direction Z. Each of the gates 60 may extend in the second horizontal direction Y.

The gates 60 may vertically overlap the channel regions 50ch of the active patterns 50. Each of the gates 60 may surround the channel region 50ch of the active pattern 50. Each of the gates 60 may include a gate electrode 70 vertically overlapping the active pattern 50, and a gate dielectric layer 65 between the active pattern 50 and the gate electrode 70. Each of the gates 60 may extend in the second horizontal direction Y, and may surround the active pattern 50. For example, in each of the gates 60, the gate electrode 70 may cover an upper surface and a lower surface of the active pattern 50, and may cover side surfaces of the active pattern 50 opposite each other in the second horizontal direction Y, and may extend in the second horizontal direction Y, and the gate dielectric layer 65 may be disposed between the gate electrode 70 and the active pattern 50.

**In** the gate electrodes 70 and the active patterns 50, among a gate electrode 70 and an active pattern 50, adjacent to each other, the gate electrode 70 may not vertically overlap the first source/drain region 50sd1 of the active pattern 50.

**In** the gate electrodes 70 and the active patterns 50, among a gate electrode 70 and an active pattern 50, adjacent to each other, the gate electrode 70 may not vertically overlap the second source/drain region 50sd2 of the active pattern 50.

**In** an example, a length of the first source/drain region 50sd1 in the first horizontal direction X may be different from a length of the second source/drain region 50sd2 in the first horizontal direction X.

In an example, a length of the first source/drain region 50sd1 in the first horizontal direction X may be greater than a length of the second source/drain region 50sd2 in the first horizontal direction X, but example embodiments are not limited thereto. For example, a length of the first source/drain region 50sd1 in the first horizontal direction X may be smaller than a length of the second source/drain region 50sd2 in the first horizontal direction X.

The buffer structures 30 may be disposed between the material patterns 40 and the active patterns 50. The buffer structures 30 may be in contact with the material patterns 40 and the active patterns 50.

Hereinafter, one material pattern 40 among the material patterns 40 and one buffer structure 30 contacting the one material pattern 40 will be mainly described.

The active patterns 50 may include first active patterns 50_1 disposed between the first data storage structure 5_1 and the material pattern 40, and second active patterns 50_2 disposed between the second data storage structure 5_2 and the material pattern 40.

The gates 60 may include first gates 60_1 disposed between the first data storage structure 5_1 and the material pattern 40, and second gates 60_2 disposed between the second data storage structure 5_2 and the material pattern 40. The first gates 60_1 may be spaced apart from each other in the vertical direction Z, may vertically overlap the first active patterns 50_1, and may surround the channel regions 50ch of the first active patterns 50_1. The second gates 60_2 may be spaced apart from each other in the vertical direction Z, may vertically overlap the second active patterns 50_2, and may surround the channel regions 50ch of the second active patterns 50_2.

The buffer structure 30 may be disposed between the material pattern 40 and the first active patterns 50_1, and between the material pattern 40 and the second active patterns 50_2.

The buffer structure 30 may cover side surfaces of the material pattern 40 opposite each other in the first horizontal direction X, and may cover a lower surface of the material pattern 40. The buffer structure 30 may not cover side surfaces of the material pattern 40 opposite each other in the second horizontal direction Y.

The buffer structure 30 may include a first buffer portion 30_1 located between the material pattern 40 and the first active patterns 50_1, a second buffer portion 30_2 located between the material pattern 40 and the second active patterns 50_2, and a third buffer portion 30_3 covering the lower surface of the material pattern 40.

Hereinafter, the first active pattern 50_1 among the active patterns 50 will be mainly described.

The material pattern 40 may be doped with a first impurities. For example, the first impurities may be a group V element, for example, at least one of phosphorus (P) or arsenic (As).

The material pattern 40 may include a first semiconductor material layer doped with the first impurities.

The material pattern 40 may include silicon. The material pattern 40 may include a first polysilicon layer. For example, the material pattern 40 may include a first polysilicon layer doped with the first impurities, for example, at least one of phosphorus (P) or arsenic (As), to have N-type conductivity. The material pattern 40 may have N-type conductivity.

The buffer structure 30 may include a second semiconductor material layer doped with the first impurities. In an example, at least a portion of the buffer structure 30 may include a crystalline material layer. The buffer structure 30 may include a second polysilicon layer. For example, the buffer structure 30 may include a second polysilicon layer doped with the first impurities, for example, at least one of phosphorus (P) or arsenic (As), to have N-type conductivity. The buffer structure 30 may have N-type conductivity.

In an example, the buffer structure 30 may include a silicon layer doped with carbon, or a silicon carbide (SiC) layer. For example, the buffer structure 30 may further be doped with the first impurities in a polysilicon layer doped with carbon. The buffer structure 30 may include a polysilicon layer doped with carbon and the first impurities, or a silicon carbide layer doped with the first impurities.

The first and second source/drain regions 50sd1 and 50sd2 may be doped with the first impurities, for example, at least one of phosphorus (P) or arsenic (As). The material pattern 40 and the first source/drain region 50sd1 may have the same conductivity, for example, N-type conductivity.

In an example embodiment, the first impurities doped into the material pattern 40 may diffuse into the buffer structure 30 and the first active pattern 50_1. Therefore, the buffer structure 30 may include the first impurities diffused from the material pattern 40, and the first source/drain region 50sd1 of the first active pattern 50_1 may include the first impurities diffused from the material pattern 40.

Because the first source/drain region 50sd1 may be formed by the first impurities doped in the material pattern 40 diffusing into the active pattern 50, the material pattern 40 and the first source/drain region 50sd1 may be doped with the same first impurities. Therefore, a maximum concentration of the first impurities of the material pattern 40 may be higher than a maximum concentration of the first impurities of the first source/drain region 50sd1.

The data storage structures 5 may be memory cell capacitors capable of storing information in a memory such as a dynamic random access memory (DRAM) or the like. The data storage structures 5 may include the first data storage structures 5_1 electrically connected to the second source/drain regions 50sd2 of the first active patterns 50_1, and the second data storage structures 5_2 electrically connected to the second source/drain regions 50sd2 of the second active patterns 50_2.

Each of the data storage structures 5 may include first electrodes 10, a second electrode 20, and a dielectric layer 15 between the first electrodes 10 and the second electrode 20.

The first electrodes 10 may be electrically connected to the second source/drain regions 50sd2 of the active patterns 50. Each of the first electrodes 10 may include a first portion connected to the second source/drain region 50sd2, and a second portion extending away from an edge of the first portion in a direction away from the second source/drain region 50sd2. Therefore, each of the first electrodes 10 may have a cylinder shape or a pillar shape exposed in a direction away from the second source/drain region 50sd2.

The second electrode 20 may include a first material layer 19a contacting the first dielectric layer 15, and a second material layer 19b contacting the first material layer 19a.

The second electrode 20 may include a plate portion 20P1 extending in the vertical direction Z and the second horizontal direction Y, and protruding portions 20P2 extending in a direction toward the first electrodes 10 from the plate portion 20P1. In an illustrative example, each of the first electrodes 10 may cover side, lower, and upper surfaces of the protruding portion 20P2.

Next, various modified examples will be described. Description of the modified examples will focus on modified or replaced elements. Elements described above may be directly cited without a separate detailed description, or the description thereof may be omitted. In addition, the modified or replaced elements described below will be described below with reference to the drawings, but the modified or replaced elements may be combined with each other or with the elements described above to form a semiconductor device according to an example embodiment.

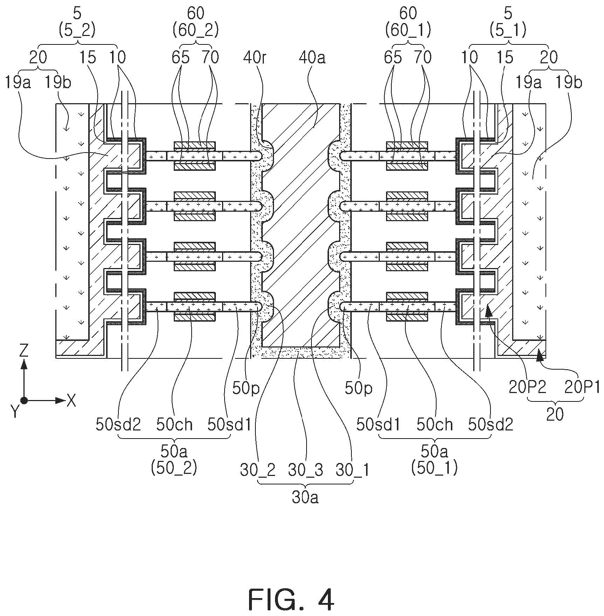

Referring to FIGS. 4 to 11, FIGS. 12A and 12B, semiconductor devices according to example embodiments will be described. FIGS. 4 to 11, FIGS. 12A and 12B are cross-sectional views illustrating modified examples of some elements in a cross-sectional structure like FIG. 3 taken along line I-I' of FIG. 2.

In an example, referring to FIG. 4, the material pattern 40 (FIG. 3), the active patterns 50 (FIG. 3), and the buffer structure 30 (FIG. 3), described above, may be replaced with a material pattern 40a, active patterns 50a, and a buffer structure 30a.

Each of the active patterns 50 (FIG. 3) described above may be replaced with the active pattern 50a having a protruding portion 50p protruding in a direction toward the material pattern 40a. The buffer structure 30 (FIG. 3) described above may be replaced with the buffer structure 30a covering upper, lower, and side surfaces of the protruding portion 50p. The material pattern 40 (FIG. 3) described above may be replaced with the material pattern 40a having side surfaces 40r recessed in a direction away from the active patterns 50a.

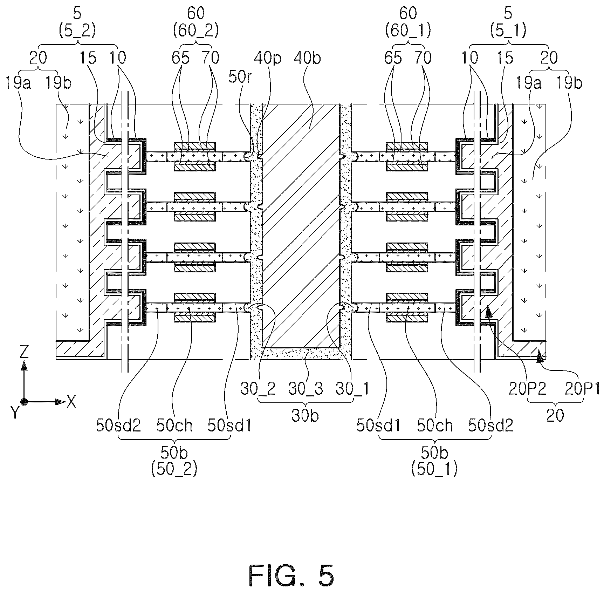

**In** an example, referring to FIG. 5, the material pattern 40 (FIG. 3), the active patterns 50 (FIG. 3), and the buffer structure 30 (FIG. 3), described above, may be replaced with a material pattern 40b, active patterns 50b, and a buffer structure 30b.

Each of the active patterns 50 (FIG. 3) described above may be replaced with the active pattern 50b having side surfaces 50r recessed in a direction facing away from the material pattern 40b. The material pattern 40 (FIG. 3) described above may be replaced with the material pattern 40b having protruding portions 40p protruding in a direction toward the active patterns 50a. The buffer structure 30 (FIG. 3) described above may be replaced with the buffer structure 30b disposed between the material patterns 40b and the active patterns 50b.

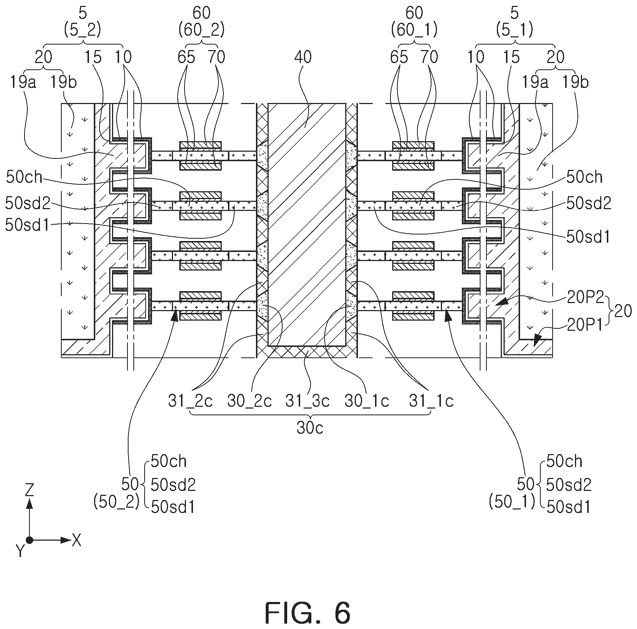

In an example, referring to FIG. 6, the buffer structure 30 (FIG. 3) described above may be replaced with a buffer structure 30c.

The first buffer portion 30_1 (FIG. 3) described above may be replaced with first dummy buffer portions 31_1c spaced apart from each other in the vertical direction, and first buffer portions 30_1c disposed between the first dummy buffer portions 31_1c, connected to first active patterns 50_1, and spaced apart from each other in the vertical direction Z. The first buffer portions 30_1c may extend from the first dummy buffer portions 31_1c.

The second buffer portion 30_2 (FIG. 3) described above may be replaced with second dummy buffer portions 31_2c spaced apart from each other in the vertical direction, and second buffer portions 30_2c disposed between the second dummy buffer portions 31_2c, connected to second active patterns 50_2, and spaced apart from each other in the vertical direction Z. The second buffer portions 30_2c may extend from the second dummy buffer portions 31_2c.

The third buffer portion 30_3 (FIG. 3) described above may be replaced with a third dummy buffer portion 31_3c extending from a lowest first dummy buffer portion 31_1c among the first dummy buffer portions 31_1c and a lowest second dummy buffer portion 31_2c among the second dummy buffer portions 31_2c, and covering a lower surface of a material pattern 40.

Therefore, the buffer structure 30c may include the first dummy buffer portions 31_1c, the first buffer portions 30_1c, the second dummy buffer portions 31_2c, the second buffer portions 30_2c, and the third dummy buffer portion 31_3c.

The first buffer portions 30_1c and the second buffer portions 30_2c may be doped with the first impurities described above. For example, the first buffer portions 30_1c and the second buffer portions 30_2c may include an epitaxial layer doped with the first impurities. For example, the first buffer portions 30_1c and the second buffer portions 30_2c may include an epitaxial layer recrystallized according to crystal structures of active patterns 50. The first buffer portions 30_1c and the second buffer portions 30_2c may include an epitaxial semiconductor layer. The first buffer portions 30_1c and the second buffer portions 30_2c may include an epitaxial silicon layer.

The first dummy buffer portions 31_1c, the second dummy buffer portions 31_2c, and the third dummy buffer portions 31_3c may be doped with the first impurities described above. The first dummy buffer portions 31_1c, the second dummy buffer portions 31_2c, and the third dummy buffer portions 31_3c may have different crystallinities from the first buffer portions 30_1c and the second buffer portions 30_2c. For example, the first dummy buffer portions 31_1c, the second dummy buffer portions 31_2c, and the third dummy buffer portions 31_3c may include at least one of an amorphous silicon layer or a polysilicon layer.

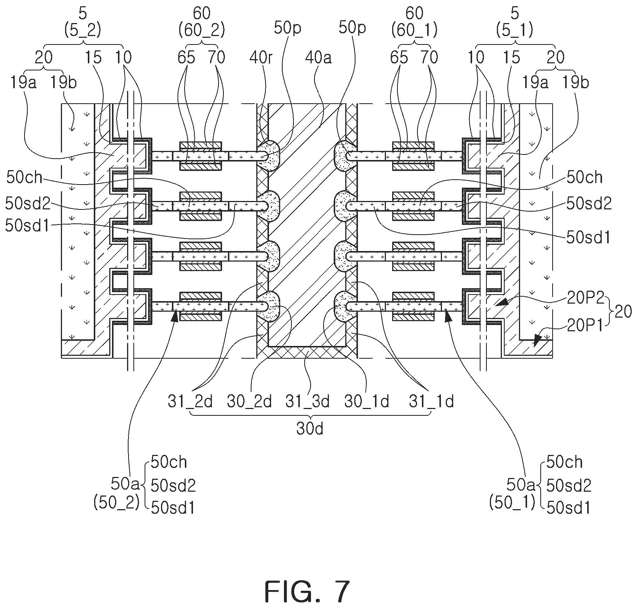

In an example, referring to FIG. 7, the buffer structure 30a (FIG. 4) described above may be replaced with a buffer structure 30d.

The first buffer portion 30_1 (FIG. 4) of the buffer structure 30a (FIG. 4) described above may be replaced with first dummy buffer portions 31_1d spaced apart from each other in the vertical direction, and first buffer portions 30_1d disposed between the first dummy buffer portions 31_1d, connected to first active patterns 50_1, and spaced apart from each other in the vertical direction Z. The first buffer portions 30_1d may extend from the first dummy buffer portions 31_1d. The second buffer portion 30_2 (FIG. 4) of the buffer structure 30a (FIG. 4) described above may be replaced with second dummy buffer portions 31_2d spaced apart from each other in the vertical direction, and second buffer portions 30_2d disposed between the second dummy buffer portions 31_2d, connected to second active patterns 50_2, and spaced apart from each other in the vertical direction Z. The second buffer portions 30_2d may extend from the second dummy buffer portions 31_2d. The third buffer portion 30_3 (FIG. 4) described above may be replaced with a third dummy buffer portion 31_3d extending from a lowest first buffer portion 31_1d among the first dummy buffer portions 31_1d and a lowest second dummy buffer portion 31_2d among the second dummy buffer portions 31_2d and covering a lower surface of a material pattern 40a. Therefore, the buffer structure 30d may include the first dummy buffer portions 31_1d, the first buffer portions 30_1d, the second dummy buffer portions 31_2d, the second buffer portions 30_2d, and the third dummy buffer portion 31_3d.

The first and second dummy buffer portions 31_1d and 31_2d and the third dummy buffer portion 31_3d may be formed of the same material as the first and second dummy buffer portions 31_1c and 31_2c (FIG. 6) and the third dummy buffer portion 30_3c (FIG. 6), described above. The first and second buffer portions 30_1d and 30_2d may be formed of the same material as the first and second buffer portions 30_1c and 30_2c (FIG. 6) described above.

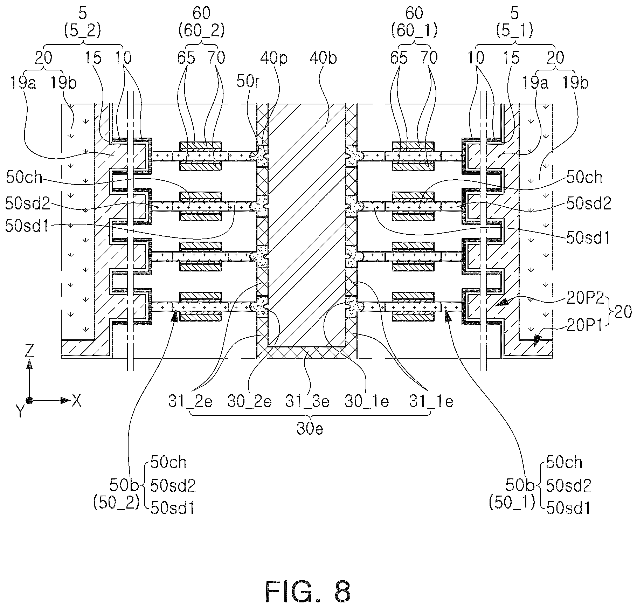

In an example, referring to FIG. 8, the buffer structure 30b (FIG. 5) described above may be replaced with a buffer structure 30e.

The first buffer portion 30_1 (FIG. 5) of the buffer structure 30b (FIG. 5) described above may be replaced with first dummy buffer portions 31_1e and first buffer portions 30_1e. The first dummy buffer portions 31_1e may be spaced apart from each other in the vertical direction. The first buffer portions 30_1e may be disposed between the first dummy buffer portions 31_1e, connected to first active patterns 50_1, and spaced apart from each other in the vertical direction Z. The first buffer portions 30_1e may extend from the first dummy buffer portions 31_1e. The second buffer portion 30_2 (FIG. 5) of the buffer structure 30b (FIG. 5) described above may be replaced with second dummy buffer portions 31_2e and second buffer portions 30_2e. The second dummy buffer portions 31_2e may be spaced apart from each other in the vertical direction. The second buffer portions 30_2e may be disposed between the second dummy buffer portions 31_1e, connected to second active patterns 50_2, and spaced apart from each other in the vertical direction Z. The second buffer portions 30_2e may extend from the second dummy buffer portions 31_2e. The third buffer portion 30_3 (FIG. 5) described above may be replaced with a third dummy buffer portion 31_3e extending from a lowest first buffer portion 31_1e among the first dummy buffer portions 31_1e and a lowest second dummy buffer portion 30_2e among the second dummy buffer portions 30_2e and covering a lower surface of a material pattern 40b. Therefore, the buffer structure 30e may include the first dummy buffer portions 31_1e, the first buffer portions 30_1e, the second dummy buffer portions 31_2e, the second buffer portions 30_2e, and the third dummy buffer portion 31_3e.

The first and second dummy buffer portions 31_1e and 31_2e and the third dummy buffer portion 31_3e may be formed of the same material as the first and second dummy buffer portions 31_1c and 31_2c (FIG. 6) and the third dummy buffer portion 30_3c (FIG. 6) described above. The first and second buffer portions 30_1e and 30_2e may be formed of the same material as the first and second buffer portions 30_1c and 30_2c (FIG. 6) described above.

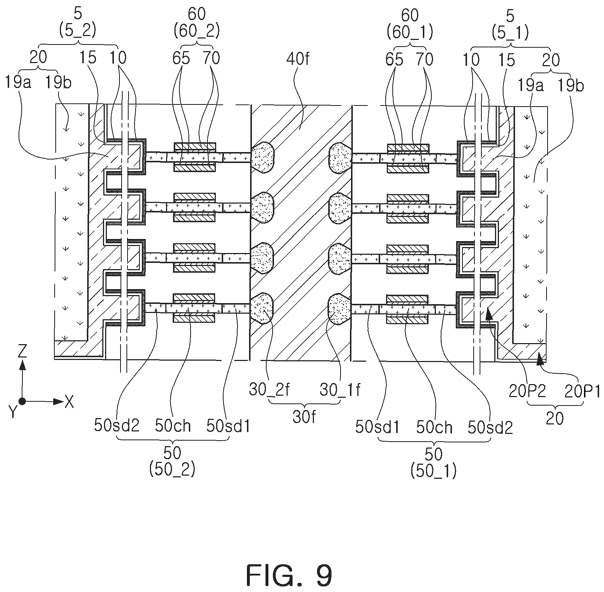

In an example, referring to FIG. 9, the buffer structure 30 (FIG. 3) described above may be replaced with a buffer structure 30f.

The buffer structure 30f may include first epitaxial layers 30_1f epitaxially grown from first active patterns 50_1, and second epitaxial layers 30_2f epitaxially grown from second active patterns 50_2, by a selective epitaxial growth process.

The first and second epitaxial layers 30_1f and 30_2f may be epitaxial semiconductor layers doped with the first impurities. The first and second epitaxial layers 30_1f and 30_2f may be epitaxial silicon layers doped with the first impurities.

In an example, the first epitaxial layers 30_1f may be spaced apart from each other in the vertical direction Z. However, example embodiments are not limited thereto. For example, the first epitaxial layers 30_1f may be connected to each other in the vertical direction Z.

In an example, the second epitaxial layers 30_2f may be spaced apart from each other in the vertical direction Z. However, example embodiments are not limited thereto. For example, the second epitaxial layers 30_2f may be connected to each other in the vertical direction Z.

The material pattern 40 (FIG. 3) described above may be replaced with a material pattern 40f. The material pattern 40f may cover upper, lower, and side surfaces of each of the first and second epitaxial layers 30_1f and 30_2f.

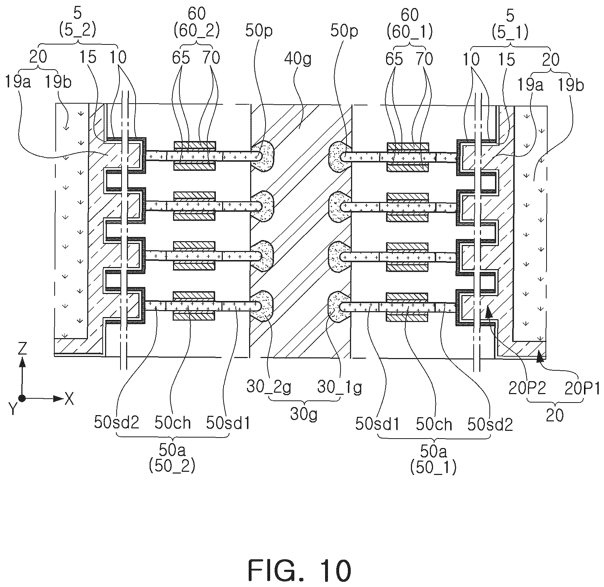

In an example, referring to FIG. 10, the buffer structure 30a (FIG. 4) described above may be replaced with a buffer structure 30g.

The buffer structure 30g may include first epitaxial layers 30_1g epitaxially grown from protruding portions 50p of first active patterns 50_1, and second epitaxial layers 30_2g epitaxially grown from protruding portions 50p of second active patterns 50_2, by a selective epitaxial growth process.

The first and second epitaxial layers 30_1g and 30_2g may include the same material as the first and second epitaxial layers 30_1f and 30_2f (FIG. 9) described above.

The material pattern 40a (FIG. 4) described above may be replaced with a material pattern 40g. The material pattern 40g may cover upper, lower, and side surfaces of each of the first and second epitaxial layers 30_1g and 30_2g.

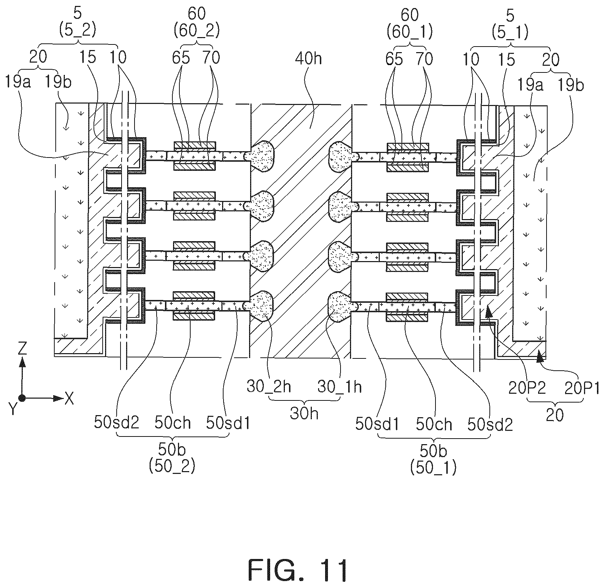

In an example, referring to FIG. 11, the buffer structure 30b (FIG. 5) described above may be replaced with a buffer structure 30h.

The buffer structure 30h may include first epitaxial layers 30_1h epitaxially grown from recessed side surfaces 50r of first active patterns 50_1, and second epitaxial layers 30_2h epitaxially grown from recessed side surfaces 50r of second active patterns 50_2, by a selective epitaxial growth process.

The first and second epitaxial layers 30_1h and 30_2h may include the same material as the first and second epitaxial layers 30_1f and 30_2f (FIG. 9) described above.

The material pattern 40b (FIG. 5) described above may be replaced with a material pattern 40h. The material pattern 40h may cover upper, lower, and side surfaces of each of the first and second epitaxial layers 30_1h and 30_2h.

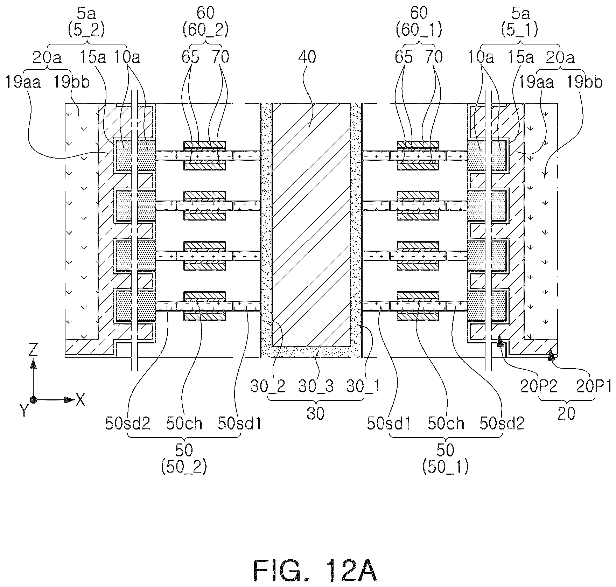

In an example, referring to FIG. 12A, the data storage structures 5 (FIGS. 3 to 11) described above may be replaced with data storage structures 5a.

Each of the data storage structures 5a may include first electrodes 10a, a second electrode 20a, and a dielectric layer 15a between the first electrodes 10a and the second electrode 20a.

The first electrodes 10a may be electrically connected to second source/drain regions 50sd2 of active patterns 50. Each of the first electrodes 10a may have a cylinder shape or a pillar shape connected to and extending in a direction away from the second source/drain region 50sd2.

The second electrode 20a may include a first material layer 19aa contacting the first dielectric layer 15a, and a second material layer 19bb contacting the first material layer 19aa. The second electrode 20a may include a plate portion 20P1 extending in the vertical direction Z and the second horizontal direction Y, and protruding portions 20P2 extending from the plate portion 20P1. In an example, the second electrodes 20a may cover side, lower, and upper surfaces of each of the first electrodes 10a.

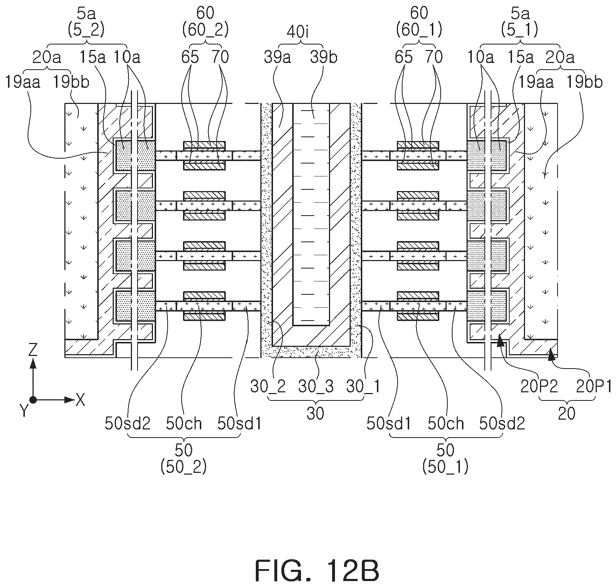

In an example, referring to FIG. 12B, the material patterns 40, 40a, 40b, 40f, 40g, and 40h in FIGS. 2 to 11 and FIG. 12A may be replaced with a material pattern 40i including at least two material layers 39a and 39b. For example, the material pattern 40i may include a first material layer 39b having a pillar shape that extends in the vertical direction Z, and a second material layer 39a disposed between the first material layer 39b and a buffer structure 30.

The second material layer 39a may include the same material as the material pattern 40 (FIG. 3) described above. For example, the second material layer 39a may include a semiconductor material doped with the first impurities, for example, doped polysilicon.

The first material layer 39b may include a conductor including at least one of doped polysilicon, metal, metal nitride, or metal silicide, having conductivity. The first material layer 39b may serve to improve resistance of the material pattern 40i.

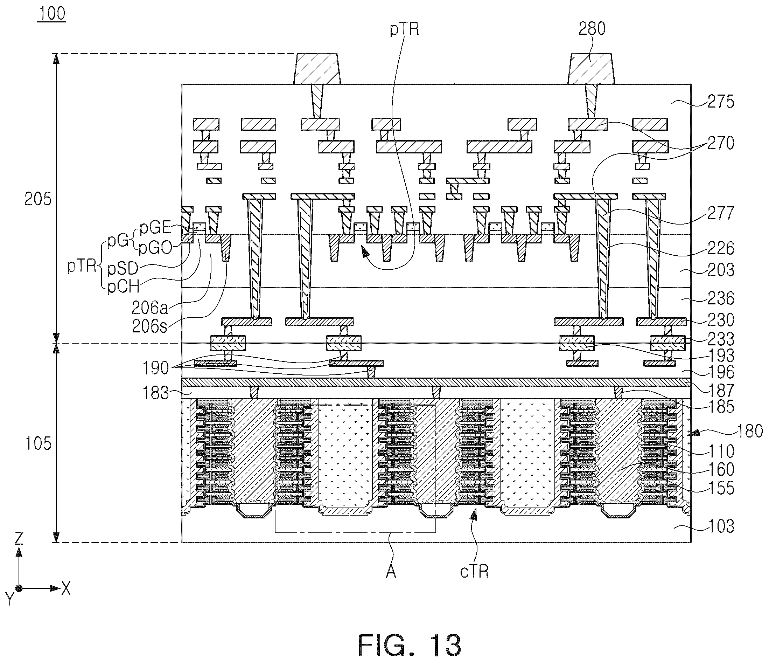

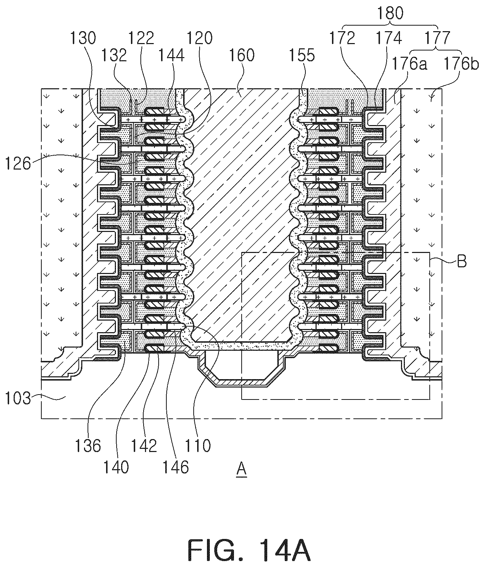

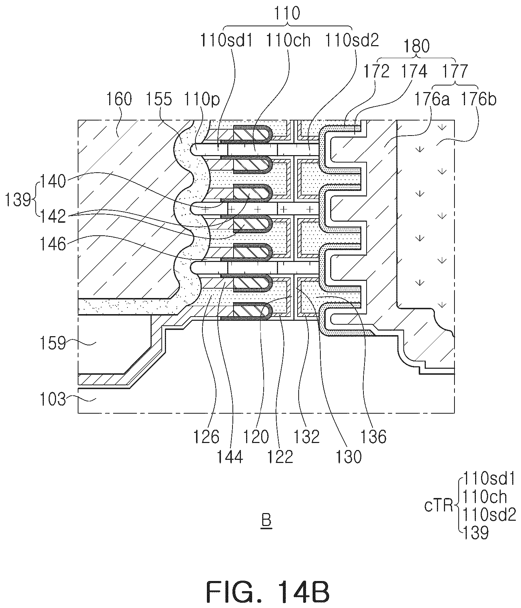

Next, with reference to FIGS. 13, 14A, and 14B, a semiconductor device according to an example embodiment will be described. In FIGS. 13, 14A, and 14B, FIG. 13 is a cross-sectional view illustrating a semiconductor device according to an example embodiment, FIG. 14A is a partially enlarged view illustrating a region indicated by 'A' in FIG. 13, and FIG. 14B is a partially enlarged view illustrating a region indicated by 'B' in FIG. 14A.

Referring to FIGS. 13, 14A, and 14B, a semiconductor device 100 according to an example embodiment may include a first structure 105 and a second structure 205 vertically overlapping the first structure 105. The second structure 205 may be disposed on the first structure 105.

The first structure 105 is an example of the first structure ST1 described in FIG. 1.

The second structure 205 is an example of the second structure ST2 described in FIG. 1.

The first structure 105 may be a memory region including memory cells disposed three-dimensionally, and the second structure 205 may be a peripheral region including a peripheral circuit.

The first structure 105 may include a substrate 103, and cell transistors cTR, data storage structures 180, material patterns 160, and buffer structures 155, disposed on the substrate.

The data storage structures 180 of the first structure 105 may be spaced apart from each other in the first horizontal direction X. A single material pattern 160 among the material patterns 160 may be disposed between a pair of adjacent data storage structures 180.

The first structure 105 may include active patterns 110 spaced apart from each other and stacked in the vertical direction Z. Each of the active patterns 110 may include a first source/drain region 110sd1, a channel region 110ch, and a second source/drain region 110sd2.

The active patterns 110 may be formed of the same material as the active patterns 50 described above. Each of the active patterns 110 may include a first source/drain region 110sd1, a channel region 110ch, and a second source/drain region 110sd2, corresponding to the first source/drain region 50sd1, the channel region 50ch, and the second source/drain region 50sd2, described above.

The first structure 105 may include gates 139 spaced apart from each other and stacked in the vertical direction Z. The gates 139 may vertically overlap the channel regions 110ch of the active patterns 110. The gates 139 may correspond to the gates 60 described above. Each of the gates 139 may include a gate electrode 142 extending in the second horizontal direction Y, perpendicular to the first horizontal direction X, and surrounding the channel region 110ch, and a gate dielectric layer 140 between the gate electrode 142 and the channel region 110ch.

The gate electrodes 142 may include word lines in a memory such as a DRAM.

Each of the cell transistors cTR may include the first source/drain region 110sd1, the channel region 110ch, the second source/drain region 110sd2, and the gate 139.

The data storage structures 180 may be memory cell capacitors capable of storing information in a memory such as a DRAM or the like. The data storage structures 180 may correspond to the data storage structures 5 described above in FIGS. 2 to 12B. Each of the data storage structures 180 may include first electrodes 172, a second electrode 177, and a dielectric layer 174 between the first electrodes 172 and the second electrode 177.

The first electrodes 172 may be electrically connected to the second source/drain regions 110sd2 of the active patterns 110. The first electrodes 172 may have substantially the same shape as the first electrodes 10 in FIGS. 2 and 3, but example embodiments are not limited thereto. For example, the first electrodes 172 may have substantially the same shape as the first electrodes 10a in FIG. 12A, for example, a pillar shape extending in the first horizontal direction X.

The second electrode 177 may include a first material layer 176a contacting the dielectric layer 174, and a second material layer 176b contacting the first material layer 176a. The second electrode 177 may have substantially the same shape as the second electrode 20 (FIGS. 2 and 3) described above.

Hereinafter, among the data storage structures 180 and the material patterns 160, a data storage structure 180 and a material pattern 160, adjacent to each other, will be described.

The material pattern 160 may be formed of the same material as the material patterns 40, 40a, 40b, 40f, 40g, and 40h in FIGS. 2 to 11 and FIG. 12A, or the same material as the material pattern 40i in FIG. 12B.

The buffer structure 155 may cover both side surfaces of the material pattern 160 opposite each other in the first horizontal direction X, and a lower surface of the material pattern 160. The buffer structure 155 may be in contact with and connected to the first source/drain regions 110sd1 of the active patterns 110.

The buffer structure 155 may be formed of the same material as the buffer structure 30 described in FIGS. 2 and 3.

In an example, each of the active patterns 110 may include a protruding portion 110p protruding in a direction toward the material pattern 160, such as the protruding portion 50p of FIG. 4. The buffer structure 155 may cover upper, lower, and side surfaces of the protruding portion 110p, such as the buffer structure 30a of FIG. 4.

The first structure 105 may further include a gate capping layer 144 and an insulating layer 146. The gate capping layer 144 may be disposed between the gate electrode 142 and the buffer structure 155. A portion of the gate dielectric layer 140 may be disposed between the active pattern 110 and the gate capping layer 144. The gate capping layer 144 may be spaced apart from the buffer structure 155, and the insulating layer 146 may be disposed between the gate capping layer 144 and the buffer structure 155. The insulating layer 146 may be in contact with the buffer structure 155. The gate capping layers 144 may include an insulating material, for example, at least one of silicon nitride, silicon oxynitride, or silicon oxycarbide.

The first structure 105 may further include an insulating layer 159 between the substrate 103 and the material pattern 160. The insulating layer 159 may be disposed below the buffer structure 155. The buffer structure 155 may cover a lower surface of the material pattern 160.

The first structure 105 may further include a first buffer layer 120, a first liner 122, and a first gap-fill insulating layer 126, disposed between the active patterns 110. The first buffer layer 120, the first liner 122, and the first gap-fill insulating layer 126 may be in contact with the gate dielectric layer 140. For example, the first buffer layers 120 may extend horizontally on upper and lower surfaces of the active patterns 110, and may extend vertically between the active patterns 110. The first liner 122 may be conformally disposed on the first buffer layer 120. The first gap-fill insulating layer 126 may fill a space between adjacent gate dielectric layers 140. The first gap-fill insulating layer 126 may be in contact with the gate capping layer 144 and the buffer structure 155. The first buffer layer 120 and the first gap-fill insulating layer 126 may include silicon oxide, and the first liner 122 may include silicon nitride.

The first structure 105 may further include a second buffer layer 130, a second liner 132, and a second gap-fill insulating layer 136, disposed between the active patterns 110. The second buffer layer 130, the second liner 132, and the second gap-fill insulating layer 136 may be in contact with the first electrode 172. For example, the second buffer layers 130 may extend horizontally on the upper and lower surfaces of the active patterns 110, and may extend vertically between the active patterns 110. The second liner 132 may be conformally disposed on the second buffer layer 130. The second gap-fill insulating layer 136 may be disposed on the second liner 132, and may fill a space between adjacent active patterns 110. The second buffer layer 130 and the second gap-fill insulating layer 136 may include silicon oxide, and the second liner 132 may include silicon nitride.

The first structure 105 may further include an insulating layer 183 covering the material patterns 160, the buffer structures 155, and the data storage structures 180, contact plugs 185 penetrating the insulating layer 183 and connected to the material patterns 160, and a conductive line 187 disposed on the insulating layer 183 and connected to the contact plugs 185.

The conductive line 187 may extend in the first horizontal direction X. The conductive line 187 may electrically connect the material patterns 160 arranged in the first horizontal direction X through the contact plugs 185.

The first structure 105 may further include an insulating structure 196 on the conductive line 187, interconnection structures 190 embedded in the insulating structure 196, and first bonding pads 193 having an upper surface, coplanar with an upper surface of the insulating structure 196.

The second structure 205 may include a peripheral circuit such as a sense amplifier, a sub-word line driver, or the like in the second bank region BA2 described in FIG. 1. For example, the second structure 205 may include peripheral transistors pTR that may form the peripheral circuit. For example, the first source/drain regions 110sd1 of the cell transistors cTR disposed in the first structure 105 may be electrically connected to the peripheral transistors pTR that may form a sense amplifier disposed in the second structure 205, through the buffer structure 155, the material pattern 160, and the conductive line 187.

In FIG. 13, an electrical connection relationship between the peripheral transistors pTR and the cell transistors cTR is illustrative, and example embodiments are not limited to the arrangement illustrated in FIG. 13.

The second structure 205 may further include a semiconductor body 203, a device isolation region 206s defining a peripheral active region 206a on the semiconductor body 203, peripheral source/drain regions pSD disposed in the peripheral active region 206a, a peripheral channel region pCH between the peripheral source/drain regions pSD, and a peripheral gate pG including a peripheral gate dielectric layer pGO and a peripheral gate electrode pGE, sequentially disposed on the peripheral channel region pCH.

Each of the peripheral transistors pTR may include the peripheral source/drain regions pSD, the peripheral channel region pCH, and the peripheral gate pG.

The second structure 205 may further include a lower insulating layer 236 below the semiconductor body 203, a redistribution structure 230 embedded in the lower insulating layer 236, and second bonding pads 233 connected to the redistribution structure 230 and having lower surfaces, coplanar with a lower surface of the lower insulating layer 236.

The second bonding pads 233 may be in contact with and bonded to the first bonding pads 193. The first and second bonding pads 193 and 233 may include a metal material, for example, copper.

The second structure 205 may further include an upper insulating structure 275 on the semiconductor body 203, a peripheral interconnection structure 270 embedded in the upper insulating structure 275 and electrically connected to the peripheral transistors pTR forming the peripheral circuit, and upper wirings 280 on the upper insulating structure 275.

The second structure 205 may further include through-vias 277 penetrating the semiconductor body 203 and electrically connecting the peripheral interconnection structures 270 and the redistribution structure 230, and insulating spacers 226 on side surfaces of the through-vias 277.

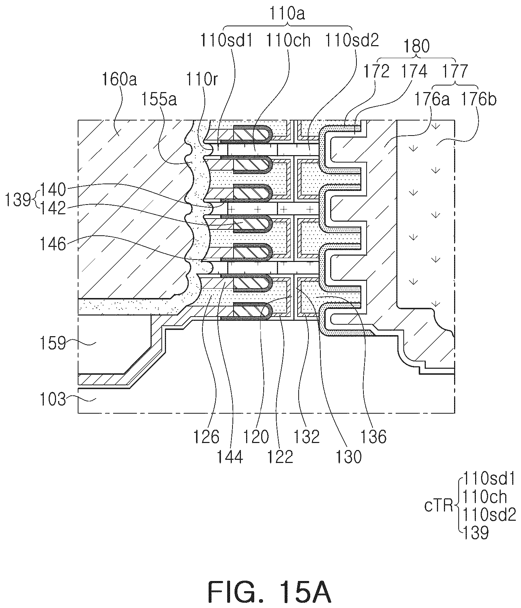

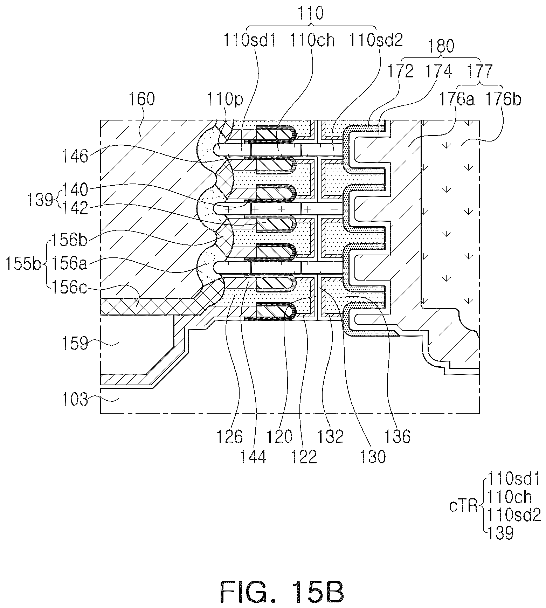

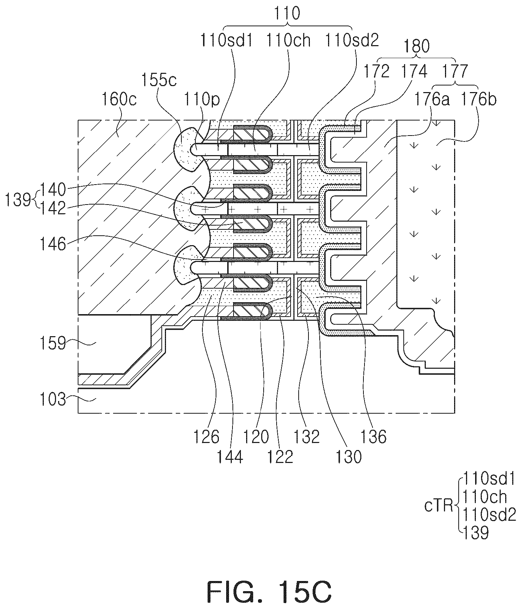

Next, with reference to FIGS. 15A, 15B, and 15C, a semiconductor device according to example embodiments will be described. FIGS. 15A, 15B, and 15C are cross-sectional views illustrating modified examples of some elements in the same cross-sectional structure as FIG. 14B.

In an example, referring to FIG. 15A, the active patterns 110 (FIGS. 14A and 14B), the buffer structure 155 (FIGS. 14A and 14B), and the material pattern 160 (FIGS. 14A and 14B), described above, may be replaced with active patterns 110a, a buffer structure 155a, and a material pattern 160a.

Each of the active patterns 110 (FIGS. 14A and 14B) described above may be replaced with the active pattern 110a having a side surface 110r recessed in a direction away from the material pattern 160a. The above-described material pattern 160 (FIGS. 14A and 14B) may be replaced with the material pattern 160a having protruding portions protruding in a direction toward the active patterns 110a. The above-described buffer structure (155 of FIGS. 14A and 14B) may be replaced with the buffer structure 155a disposed between the material patterns 160a and the active patterns 110a.

In an example, referring to FIG. 15B, the buffer structure 155 (FIGS. 14A and 14B) described above may be replaced with a buffer structure 155b.

The buffer structure 155b may include first dummy buffer portions 156b spaced apart from each other in a vertical direction, buffer portions 156a disposed between the first dummy buffer portions 156b, connected to active patterns 110, and spaced apart from each other in the vertical direction Z, and a second dummy buffer portion 156c extending from a lowermost first dummy buffer portion among the first dummy buffer portions 156b and covering a lower surface of a material pattern 160.

The first and second dummy buffer portions 156b and 156c described above may be formed of the same material as the first and second dummy buffer portions 31_1c and 31_2c (FIG. 6) and the third dummy buffer portion 31_3c (FIG. 6), described above. The buffer portions 156a may be formed of the same material as the first and second buffer portions 30_1c and 30_2c (FIG. 6) described above.

In an example, referring to FIG. 15C, the buffer structure 155 (FIGS. 14A and 14B) described above may be replaced with a buffer structure 155c.

The buffer structure 155c may include epitaxial layers epitaxially grown from active patterns 110 by a selective epitaxial growth process. The epitaxial layers of the buffer structure 155c described above may be formed of the same material as the first and second epitaxial layers 30_1f and 30_2f (FIG. 9) described in FIG. 9.

The material pattern 160 (FIGS. 14A and 14B) described above may be replaced with a material pattern 160c. The material pattern 160c may cover upper, lower, and side surfaces of each of the epitaxial layers of the buffer structure 155c.

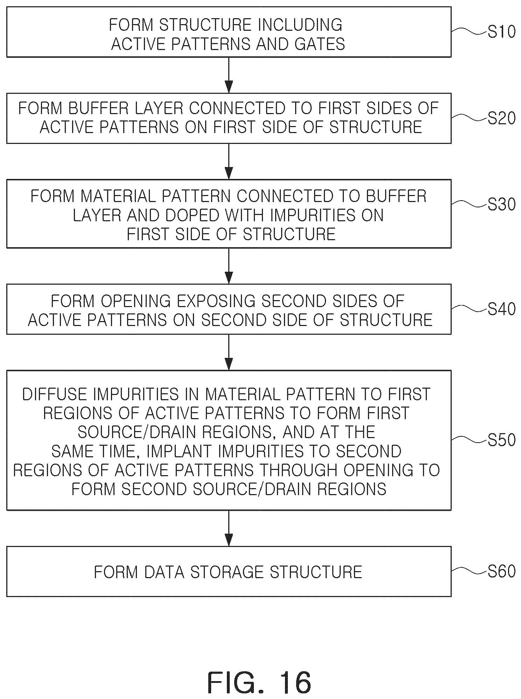

Next, with reference to FIG. 16, FIG. 17 to FIG. 23, examples of a method for forming a semiconductor device according to an example embodiment will be described.

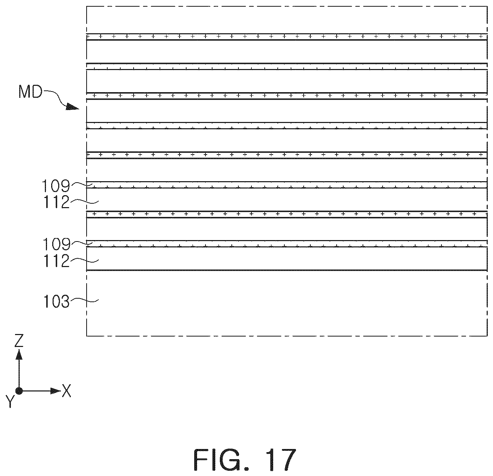

FIG. 16 is a process flow diagram illustrating a method for forming a semiconductor device according to an example embodiment, and FIGS. 17 to 23 are cross-sectional views illustrating cross-sectional structures corresponding to FIG. 14A.

Referring to FIG. 17, a mold structure MD may be formed on a substrate 103. The mold structure MD may include semiconductor material layers 109 and sacrificial layers 112, alternately stacked. Among the semiconductor material layers 109 and the sacrificial layers 112, a lowermost layer may be a lowermost sacrificial layer 112, and an uppermost layer may be an uppermost sacrificial layer 112. The sacrificial layers 112 may include a material having etching selectivity with respect to a material of the semiconductor material layers 109.

In an example embodiment, the semiconductor material layers 109 may include silicon, and the sacrificial layers 112 may include silicon-germanium, silicon oxide, silicon nitride, silicon carbide, silicon oxynitride, or a combination thereof. For example, the semiconductor material layers 109 may include a single-crystal silicon layer, and the sacrificial layers 112 may include a silicon-germanium layer.

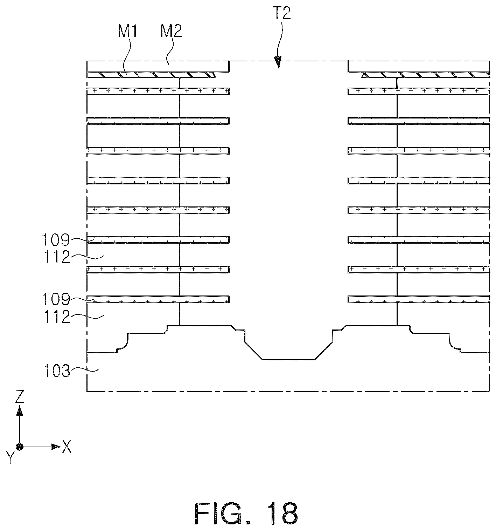

Referring to FIG. 18, trenches T2 may be formed. A first mask layer M1 and a second mask layer M2 may be formed. The second mask layer M2 may be formed on the first mask layer M1, ends of the second mask layer M2 may extend past ends of the first mask layer M1. and the ends of the second mask layer M2 may correspond to ends of the semiconductor material layers 109. The trenches T2 may be formed by anisotropically etching the mold structure MD using the first mask layer M1 and the second mask layer M2 as etching masks. Each of the trenches T2 may extend in the second horizontal direction Y. In the etching process, an upper surface of the substrate 103 may be partially etched.

Afterwards, the sacrificial layers 112 may be partially etched. The semiconductor material layers 109 having etching selectivity with respect to the sacrificial layers 112 may not be etched. As the sacrificial layers 112 is etched, upper and lower surfaces of a portion of the semiconductor material layers 109 may be exposed by the trenches T2.

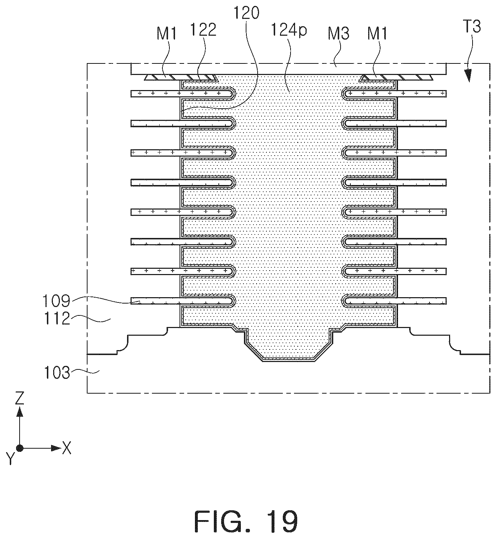

Referring to FIG. 19, the semiconductor material layers 109 exposed by the trenches T2 may be partially etched. For example, portions of the semiconductor material layers 109 exposed by the trenches T2 may be etched to be spaced apart in the second horizontal direction Y.

A first buffer layer 120, a first liner 122, and a preliminary first gap-fill insulating layer 124p may be formed in the trenches T2. The first buffer layer 120 may extend conformally along the semiconductor material layers 109. The first buffer layer 120 may cover the upper surface of the substrate 103, and may cover upper and lower surfaces of the semiconductor material layers 109. The first liner 122 may be formed on the first buffer layer 120, and may be formed conformally along the first buffer layer 120. The preliminary first gap-fill insulating layer 124p may be formed on the first liner 122, and may fill the trench T2. A third mask layer M4 may be formed on the first mask layer M1 and the preliminary first gap-fill insulating layer 124p.

The first buffer layer 120, the first liner 122, and the preliminary first gap-fill insulating layer 124p may be formed of insulating materials. For example, the first buffer layer 120, the first liner 122, and the preliminary first gap-fill insulating layer 124p may include at least one of silicon oxide, silicon nitride, or silicon oxynitride. The first liner 122 may include a material having etching selectivity with respect to the first buffer layer 120 and the preliminary first gap-fill insulating layer 124p. For example, the first liner 122 may include silicon nitride, and the first buffer layer 120 and the preliminary first gap-fill insulating layer 124p may include silicon oxide.

Trenches T3 may be formed. The trenches T3 may be formed by anisotropically etching the mold structure MD using the first mask layer M1 and a third mask layer M3 as etching masks. The trenches T3 may extend in the second horizontal direction Y, and may be alternately disposed along the trenches T2 and the first horizontal direction X. In the etching process, the upper surface of the substrate 103 may be partially etched.

The sacrificial layers 112 exposed by the trenches T3 may be partially etched. For example, the sacrificial layers 112 may be partially etched by supplying an etchant into the third trenches T3. Upper and lower surfaces of a portion of the semiconductor material layers 109 may be exposed by the third trenches T3.

The semiconductor material layers 109 exposed by the trenches T3 may be partially etched. For example, portions of the semiconductor material layers 109 exposed by the trenches T3 may be etched to form active patterns 110 spaced apart in the second horizontal direction Y.

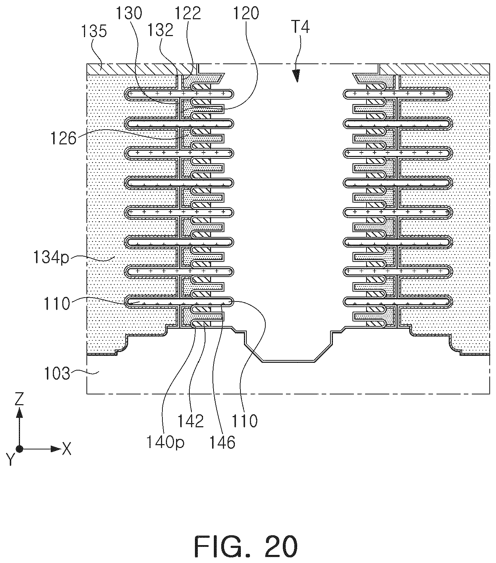

Referring to FIG. 20, a second buffer layer 130, a second liner 132, a preliminary second gap-fill insulating layer 134p, and an upper insulating layer 135 may be formed in the trenches T3. The second buffer layer 130 may conformally extend along the active patterns 110, and may be in contact with the first buffer layer 120. The second buffer layer 130 may cover a portion of the upper surface of the substrate 103 exposed by the trenches T3, and may cover upper and lower surfaces of the active patterns 110. The second liner 132 may be formed on the second buffer layer 130, and may be conformally formed along the second buffer layer 130. The preliminary second gap-fill insulating layer 134p may be formed on the second liner 132, and may fill the trenches T3. The upper insulating layer 135 may be formed on the preliminary second gap-fill insulating layer 134p.

The second buffer layer 130, the second liner 132, and the preliminary second gap-fill insulating layer 134p may be formed of insulating materials. Each of the second buffer layer 130, the second liner 132, and the preliminary second gap-fill insulating layer 134p may include at least one of silicon oxide, silicon nitride, or silicon oxynitride. The second liner 132 may include a material having etching selectivity with respect to the second buffer layer 130 and the preliminary second gap-fill insulating layer 134p. For example, the second liner 132 may include silicon nitride, and the second buffer layer 130 and the preliminary second gap-fill insulating layer 134p may include silicon oxide. The upper insulating layer 135 may include silicon nitride.

The first buffer layer 120, the first liner 122, and the preliminary first gap-fill insulating layer 124p may be partially etched.

A dielectric material layer 140p and a gate electrode 142 may be formed. For example, the first buffer layer 120, the first liner 122, and the preliminary first gap-fill insulating layer 124p may be partially etched to form trenches T4. The trenches T4 may be formed in a space in which the trenches T2 were previously disposed. The preliminary first gap-fill insulating layer 124p may be etched to form a first gap-fill insulating layer 126.

The first buffer layer 120, the first liner 122, and the preliminary first gap-fill insulating layer 124p may be partially etched to expose the upper and lower surfaces of the active patterns 110 by the trenches T4. The dielectric material layer 140p may be conformally formed along inner walls of the trenches T4. After forming a conductive material layer on the dielectric material layer 140p, the conductive material layer may be etched back to form the gate electrodes 142. The gate electrodes 142 may be formed between the active patterns 110 and the first gap-fill insulating layers 126.

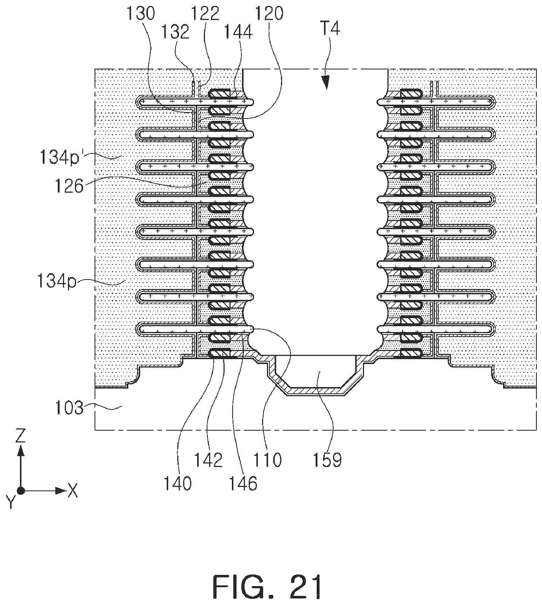

Referring to FIG. 16 and FIG. 21, the dielectric material layer 140p may be partially etched to expose the active patterns 110 by the trenches T4. The dielectric material layer 140p may be etched to form a gate dielectric layer 140. Therefore, a structure including the active patterns 110 and gates (140 and 142) may be formed (S10).

Gate capping layers 144 covering the side surfaces of the gate electrodes 142 may be formed. An insulating material may be deposited between the exposed active patterns 110 to form a first gap-fill insulating layer 126 and an insulating layer 146. The first gap-fill insulating layer 126 may be formed at a position corresponding to the preliminary first gap-fill insulating layer 124p, and may fill a space between adjacent gate capping layers 144. The insulating layer 146 may be formed on a side surface of the gate dielectric layer 140 exposed by the trench T4. Side surfaces of the active patterns 110 may be exposed by the trench T4. An insulating layer 159 may be formed to fill a recessed region of the substrate 103 within the trench T4.

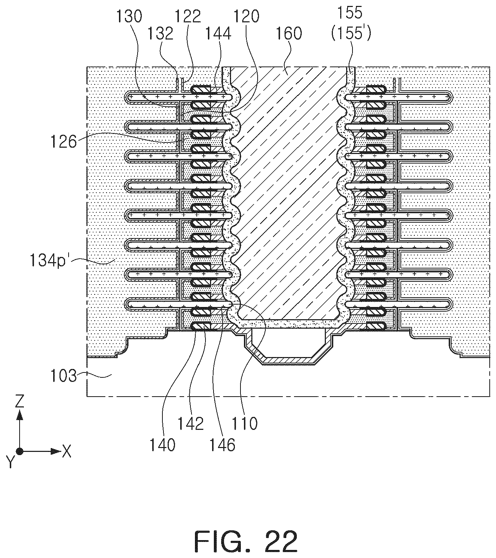

Referring to FIG. 16 and FIG. 22, a buffer layer 155' connected to first sides of the active patterns 110 may be formed on a first side of the structure (S20). For example, the buffer layer 155' may be in contact with the side surfaces of the active patterns 110 exposed by the trench T4.

In an example, the buffer layer 155' may be formed as an undoped semiconductor material layer. The buffer layer 155' may be formed as a crystallized semiconductor material layer.

In an example, the buffer layer 155' may be formed of undoped polysilicon.

In an example, the buffer layer 155' may be formed by an epitaxial process of recrystallizing the semiconductor material layer according to a crystal structure of the active patterns 110 after depositing the semiconductor material layer.

In an example, the buffer layer 155' may be formed as an epitaxial layer that may be epitaxially grown from the side surfaces of the active patterns 110 by performing a selective epitaxial growth process.

In an example, the buffer layer 155' may be formed of a carbon-doped semiconductor material, for example, as a carbon-doped silicon layer.

In an example, the buffer layer 155' may be formed as a silicon carbide layer.

In an example, the buffer layer 155' may be formed as a low-concentration semiconductor material layer doped with an impurities concentration, lower than an impurities concentration of a source/drain region.

In an example, the buffer layer 155' may be formed as a crystalline semiconductor material layer doped with arsenic (As).

A material pattern 160 connected to the buffer layer 155' and doped with an impurities may be formed on the first side of the structure (S30). Therefore, the buffer layer 155' and the material pattern 160 may fill the trench T4.

At least a portion of the material pattern 160 may include a semiconductor material doped with the impurities. For example, the material pattern 160 may include a polysilicon layer doped with the impurities.

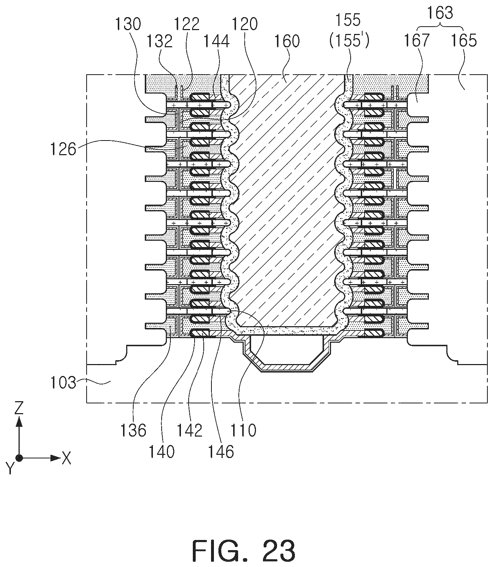

Referring to FIG. 16 and FIG. 23, a vertical opening 165 penetrating the preliminary second gap-fill insulating layer 134p and exposing the side surfaces of the active patterns 110 may be formed, the active patterns 110 exposed by the vertical opening 165 may be partially etched, and the preliminary second gap-fill insulating layer 134p may be isotropically etched to form horizontal openings 167 extending from the vertical opening 165 toward the active patterns 110. Therefore, the vertical opening 165 and the horizontal openings 167 may form an opening 163. Therefore, the opening 163 exposing second sides of the active patterns 110 may be formed on a second side of the structure (S40). The preliminary second gap-fill insulating layer 134p may be isotropically etched to form a second gap-fill insulating layer 136.

With reference to FIG. 16, and FIG. 14A and FIG. 14B, the impurities in the material pattern 160 may be diffused to first regions of the active patterns 110 to form first source/drain regions 110sd1, and at the same time, the impurities may be implanted to second regions of the active patterns 110 through the opening 163 to form second source/drain regions 110sd2 (S50).

The implanting the impurities to the second regions of the active patterns 110 through the openings 163 to form the second source/drain regions 110sd2 may include diffusing phosphorus (P) through the openings 163 into the second regions of the active patterns 110 by a gas phase doping (GPD) process.

During the GPD process, the impurities in the material pattern 160 may diffuse to the first regions of the active patterns 110 through the buffer layer 155'. Therefore, the first source/drain regions 110sd1 may be formed in the active patterns 110. The impurities may be phosphorus (P).

The impurities diffused from the material pattern 160 may remain in the buffer layer 155'. Therefore, the buffer layer 155' may be formed as a crystalline semiconductor material layer including the impurities. The buffer layer 155' doped with the impurities in this manner may be referred to as a buffer structure.

The buffer layer 155' may control a depth at which the impurities in the material pattern 160 diffuses into the active pattern 110, i.e., a junction depth of the first source/drain region 110sd1. Therefore, the buffer layer 155' may control a length of the first source/drain region 110sd1 in the first horizontal direction X. Due to the buffer layer 155', the first source/drain region 110sd1 may be formed to be offset from (i.e., to not vertically overlap) the gate electrode 142. Therefore, performance degradation of a cell transistor cTR due to gate induced drain leakage (GIDL) may be prevented.

Subsequently, a data storage structure 180 may be formed. The forming a data storage structure 180 may include forming first electrodes 172 connected to the second source/drain regions 110sd2 in the horizontal openings 167 (FIG. 23), forming a dielectric layer 174 conformally covering the first electrodes 172, and forming a second electrode 177 on the dielectric layer 174. The forming a second electrode 177 may include forming a first material layer 176a contacting the dielectric layer 174 and filling the horizontal openings 167 (FIG. 23), and forming a second material layer 176b on the first material layer 176a.

While aspects of example embodiments have been have been particularly shown and described, it will be understood that various changes in form and details may be made therein without departing from the spirit and scope of the following claims.

## Claims

1. A semiconductor device comprising:
a material pattern (40) extending in a vertical direction (Z) and doped with a first impurities;
a data storage structure (5) facing the material pattern (40) and spaced apart from the material pattern (40);
active patterns (50) provided between the material pattern (40) and the data storage structure (5), wherein the active patterns (50) are stacked and spaced apart from each other in the vertical direction (Z), and respectively comprise first source/drain regions (50sd1) adjacent to the material pattern (40) that are doped with the first impurities, second source/drain regions (50sd2) adjacent to the data storage structure (5), and channel regions (50ch) between the first source/drain regions (50sd1) and the second source/drain regions (50sd2);
gates (60) stacked and spaced apart from each other in the vertical direction (Z), wherein the gates (60) vertically overlap the channel regions (50ch) of the active patterns (50); and
a buffer structure (30) provided between the material pattern (40) and the first source/drain regions (50sd1) of the active patterns (50).

2. The semiconductor device of claim 1, wherein the buffer structure (30) comprises a semiconductor material layer.

3. The semiconductor device of claim 1 or 2, wherein the buffer structure (30) is doped with the first impurities.

4. The semiconductor device of claim 3, wherein the first impurities are phosphorus, P, or arsenic, As, and
wherein the buffer structure (30) further comprises doped carbon.

5. The semiconductor device of claim 3, wherein the first impurities are phosphorus, P, and
wherein the buffer structure (30) further comprises arsenic, As.

6. The semiconductor device of any one of claims 1 to 5, wherein the material pattern (40) has a pillar shape that extends in the vertical direction (Z), and
wherein the buffer structure (30) covers side surfaces of the material pattern (40) opposite each other in a first horizontal direction (X), and a lower surface of the material pattern (40).

7. The semiconductor device of any one of claims 1 to 6, wherein at least one of the active patterns (50a) comprises a protruding portion (50p) extending into the buffer structure (30), and
wherein the buffer structure (30a) is in contact with each of an upper surface, a lower surface, and a side surface of the protruding portion (50p).

8. The semiconductor device of any one of claims 1 to 7, wherein the material pattern (40b) comprises a protruding portion (40p) protruding toward at least one of the active patterns (50a).

9. The semiconductor device of any one of claims 1 to 8, wherein, in each of the active patterns (50), a corresponding first source/drain region (50sd1), a corresponding channel region (50ch), and a corresponding second source/drain region (50sd2) are arranged sequentially in a first direction (X), and
wherein the material pattern (40) is wider in the first direction (X) than the buffer structure (30).

10. The semiconductor device of claim 1 to 9, wherein a maximum concentration of the first impurities in the material pattern (40) is higher than a maximum concentration of the first impurities in the first source/drain regions (50sd1).

11. The semiconductor device of any one of claims 1 to 10, wherein the material pattern (40) has a first side surface and a second side surface, opposite each other in a first horizontal direction (X), and a third side surface and a fourth side surface, opposite each other in a second horizontal direction (Y),
wherein the second horizontal direction (Y) is perpendicular to the first horizontal direction (X),
wherein the buffer structure (30) covers the first and second side surfaces of the material pattern (40) opposite each other in the first horizontal direction (X) and a lower surface of the material pattern (40), and the buffer structure (30) does not cover the third and fourth side surfaces of the material pattern (40) opposite each other in the second horizontal direction (Y), and
wherein the material pattern (40) comprises a polysilicon layer having N-type conductivity.

12. The semiconductor device of any one of claims 1 to 11, wherein the buffer structure (30f) comprises an epitaxial silicon layer (30_1f, 30_2f).

13. The semiconductor device of claim 1 to 12, wherein the buffer structure (30f) comprises epitaxial layers (30_1f, 30_2f) epitaxially grown from the active patterns (50_1, 50_2).

14. The semiconductor device of any one of claim 1 to 12, wherein the buffer structure (30c) comprises buffer portions (30_1c, 30_2c) provided between the active patterns (50) and the material pattern (40), and dummy portions (31_1c, 31_2c, 31_1c) provided between the buffer portions (30_1c, 30_2c),
wherein the buffer portions (30_1c, 30_2c) comprise an epitaxial silicon layer, and
wherein the dummy portions (31_1c, 31_2c, 31_3c) comprise an amorphous silicon layer or a polysilicon layer.

15. The semiconductor device of any one of claims 1 to 12, wherein the material pattern (40) comprises a first polysilicon layer,
wherein each of the active patterns (50) comprises a single-crystal silicon layer, and
wherein the buffer structure (30) comprises a second polysilicon layer.
